# EUROPEAN PATENT APPLICATION

(11) **EP 4 757 561 A1**
(43) Date of publication of application: **10.06.2026**
(21) Application number: 24849461.9
(22) Date of filing: 24.07.2024
(51) Int. Cl.: H10K 59/80, H10K 59/38, H10K 59/122

(54) **DISPLAY DEVICE**

(30) Priority: 28.07.2023 KR 20230098939
(71) Applicant: Samsung Display Co., Ltd., Yongin-si, Gyeonggi-do 17113 (KR)
(72) Inventor: LIM, Ho, Yongin-si Gyeonggi-do 17113 (KR); LAZO MARTINEZ, Israel Esteban, Yongin-si Gyeonggi-do 17113 (KR)
(74) Representative: Dr. Weitzel & Partner
(86) International application number: PCT/KR2024/010712
(87) International publication number: WO 2025/028892

(57) **Abstract**

A display apparatus includes: a light-emitting panel including a first substrate, a plurality of light-emitting diodes on the first substrate, a bank layer including a plurality of openings, a functional layer in the openings of the bank layer, and a plurality of lenses on the functional layer; a color panel on the light-emitting panel, the color panel including a second substrate and a color filter layer on the second substrate; and a filling layer covering the plurality of lenses between the light-emitting panel and the color panel, the filling layer having a refractive index lower than a refractive index of the plurality of lenses, wherein the plurality of lenses include a first lens overlapping the functional layer, and a second lens overlapping a partition wall of the bank layer.

## Description

### Technical Field

Aspects of one or more embodiments relate to a display apparatus.

### Background Art

With the development of various electronic apparatuses such as mobile phones and large-scale televisions (TVs), various kinds of display apparatuses applicable thereto are under development. For example, liquid crystal display apparatuses including a backlight unit and organic light-emitting display apparatuses that emit light of different colors in each color area have become popular among consumers. Recently, display apparatuses including a quantum dot color conversion layer (QD-CCL) have been developed. Quantum dots are excited by incident light to emit light having a wavelength longer than a wavelength of incident light, and incident light in a low wavelength band may be used.

Recently, as the various purposes and applications of display apparatuses have diversified, various designs that improve the quality of display apparatuses have been attempted. In particular, as display apparatuses may have relatively high resolution, research to improve the color characteristics of display apparatuses has been actively conducted.

The above information disclosed in this Background section is only for enhancement of understanding of the background and therefore the information discussed in this Background section does not necessarily constitute prior art.

### Disclosure of Invention

### Technical Problem

Aspects of one or more embodiments include a display apparatus having relatively improved light efficiency.

### Solution to Problem

According to one or more embodiments, a display apparatus includes a light-emitting panel including a first substrate, a plurality of light-emitting diodes on the first substrate, a bank layer including a plurality of openings, a functional layer in the openings of the bank layer, and a plurality of lenses on the functional layer, a color panel on the light-emitting panel, the color panel including a second substrate and a color filter layer on the second substrate, and a filling layer covering the plurality of lenses between the light-emitting panel and the color panel, the filling layer having a refractive index lower than a refractive index of the plurality of lenses, wherein the plurality of lenses include a first lens overlapping the functional layer, and a second lens overlapping a partition wall of the bank layer.

According to some embodiments, the first lens and the second lens may include a same material.

According to some embodiments, a difference between a refractive index of the plurality of lenses and a refractive index of the filling layer may be in a range of 0.1 to 0.7.

According to some embodiments, a refractive index of the plurality of lenses may be in a range of 1.65 to 2.

According to some embodiments, a refractive index of the filling layer may be in a range of 1.3 to 1.6.

According to some embodiments, a thickness of the first lens may be equal to a thickness of the second lens.

According to some embodiments, a thickness of the first lens may be less than a thickness of the second lens.

According to some embodiments, the plurality of lenses may be arranged such that a virtual line connecting centers of lenses closest to one lens among the plurality of lenses forms a square.

According to some embodiments, the plurality of lenses may be arranged such that a virtual line connecting centers of lenses closest to one lens among the plurality of lenses forms a hexagon.

According to some embodiments, a distance between centers of a pair of lenses adjacent to each other among the plurality of lenses may be equal to a width of each of the lenses.

According to some embodiments, the plurality of lenses may be spaced apart from each other.

According to some embodiments, the plurality of openings of the bank layer may include a first opening, a second opening, and a third opening, the functional layer may include a first color conversion layer in the first opening of the bank layer, a second color conversion layer in the second opening of the bank layer, and a third color conversion layer in the third opening of the bank layer, the color filter layer may include a first color filter overlapping the first color conversion layer, a second color filter overlapping the second color conversion layer, and a third color filter overlapping the third color conversion layer, and the first lens may be provided as a plurality of first lenses in areas overlapping the first color conversion layer, the second color conversion layer, and the third color conversion layer, respectively.

According to some embodiments, the display apparatus may further include a low refractive layer between the filling layer and the color filter layer, the low refractive layer having a refractive index lower than a refractive index of the functional layer.

According to one or more embodiments, a display apparatus includes a substrate, a plurality of light-emitting elements on the substrate, an encapsulation layer covering the plurality of light-emitting elements, a bank layer on the encapsulation layer and having a plurality of openings, a functional layer in the plurality of openings of the bank layer, a light collection layer on the functional layer and overlapping the functional layer, a spacer on a same layer as the light collection layer on the functional layer, the spacer overlapping a partition wall of the bank layer, a filling layer on the light collection layer and the spacer, and a color filter layer on the filling layer, wherein the light collection layer has a refractive index higher than a refractive index of the filling layer.

According to some embodiments, the light collection layer and the spacer may include a same material as each other.

According to some embodiments, a difference between a refractive index of the light collection layer and a refractive index of the filling layer may be in a range of 0.1 to 0.7.

According to some embodiments, a thickness of the light collection layer may be less than or equal to a thickness of the spacer.

According to some embodiments, the display apparatus may further include a low refractive layer between the filling layer and the color filter layer, the low refractive layer having a refractive index lower than a refractive index of the functional layer.

According to one or more embodiments, a display apparatus includes a light-emitting panel including a first substrate, a plurality of light-emitting diodes on the first substrate, a bank layer including a plurality of openings, a functional layer in the openings of the bank layer, and a plurality of lenses on the functional layer, a color panel on the light-emitting panel, the color panel including a second substrate and a color filter layer on the second substrate, and a filling layer covering the plurality of lenses between the light-emitting panel and the color panel, wherein a difference between a refractive index of the plurality of lenses and a refractive index of the filling layer is in a range of 0.1 to 0.7.

According to some embodiments, the plurality of lenses may have a refractive index higher than a refractive index of the functional layer, and the filling layer may have the refractive index lower than the refractive index of the plurality of lenses.

### Advantageous Effects of Invention

According to the one or more embodiments, a display apparatus having relatively improved light output efficiency by forming a spacer and a lens in the same process operation may be provided. However, the scope of embodiments according the present disclosure is not limited to the above characteristics.

### Brief Description of Drawings

FIG. 1 is a schematic perspective view of a display apparatus according to some embodiments.
FIG. 2 is a schematic cross-sectional view of a display apparatus according to some embodiments.
FIG. 3 is a diagram of each optical layer of a functional layer of FIG. 2 according to some embodiments.
FIG. 4 is an equivalent circuit diagram of a light-emitting diode included in a display apparatus and a subpixel circuit electrically connected to the light-emitting diode, according to some embodiments.
FIG. 5 is a schematic cross-sectional view of a display apparatus according to some embodiments.
FIG. 6 is an enlarged view of a region "A" of FIG. 5 according to some embodiments.
FIG. 7 is a diagram illustrating an example of a shape of a lens according to some embodiments.
FIG. 8 is an enlarged view of a region "A" of the display apparatus of FIG. 5, according to some embodiments.
FIG. 9 is an enlarged view of a region "A" of the display apparatus of FIG. 5, according to some embodiments.
FIG. 10 is a schematic plan view of an arrangement of a plurality of lenses according to some embodiments.
FIG. 11 is a schematic plan view of an arrangement of a plurality of lenses according to some embodiments.
FIG. 12 is a schematic cross-sectional view of a display apparatus according to some embodiments.

### Mode for the Invention

Because various modifications may be applied and one or more embodiments may be implemented, specific embodiments will be shown in the drawings and described in detail in the detailed description. Effects and features of the disclosure, and methods for achieving them will be clarified with reference to embodiments described below in detail with reference to the drawings. However, the embodiments may have different forms and should not be construed as being limited to the descriptions set forth herein.

It will be understood that although terms "first" and "second" may be used herein to describe various elements, these elements should not be limited by these terms and these terms are only used to distinguish one element from another.

In the following embodiments, the singular forms include the plural forms unless the context clearly indicates otherwise.

It will be understood that terms "comprise," "include," and "have" used herein specify the presence of stated features or elements, but do not preclude the presence or addition of one or more other features or elements.

It will be further understood that, when a layer, region, or element is referred to as being "on" another layer, region, or element, it can be directly or indirectly on the other layer, region, or element. That is, for example, intervening layers, regions, or elements may be present.

Sizes of elements in the drawings may be exaggerated for convenience of explanation. In addition, because sizes and thicknesses of elements in the drawings are arbitrarily illustrated for convenience of explanation, the following embodiments are not limited thereto.

In the present specification, the expression "A and/or B" indicates A, B, or A and B. Also, the expression "at least one of A and B" indicates A, B, or A and B.

In the following embodiments, the expression "a line extends in a first direction or a second direction" may include a case in which "a line extends in a linear shape" and a case in which "a line extends in a zigzag or curved shape in a first direction or a second direction."

In the following embodiments, when an element is referred to as being "on a plane," it is understood that the element is viewed from the top, and when an element is referred to as being "on a cross-section," it is understood that the element is vertically cut and viewed from the side. In the following embodiments, when elements "overlap" each other, the elements overlap "on a plane" and "a cross-section."

Hereinafter, the embodiments will be described in detail with reference to the attached drawings, and like reference numerals in the drawings denote like reference elements.

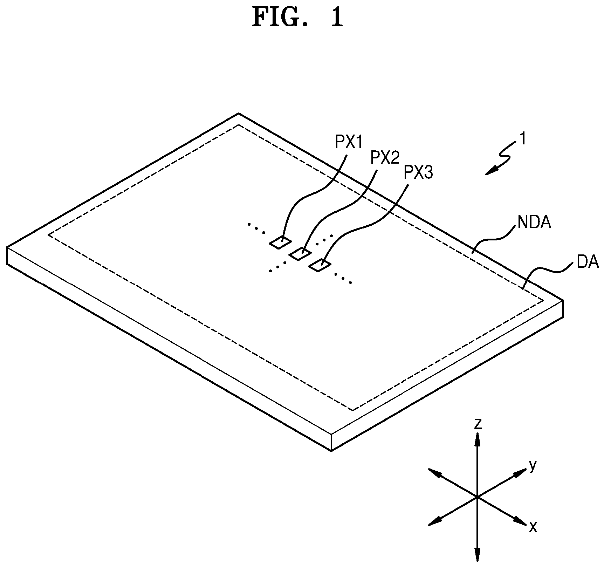

FIG. 1 is a schematic perspective view of a display apparatus 1 according to some embodiments.

Referring to FIG. 1, the display apparatus 1 may include a display area DA where images are displayed and a non-display area NDA where images are not displayed. The display apparatus 1 may display images through an array of a plurality of subpixels that are two-dimensionally located on an x-y plane in the display area DA. Each subpixel may emit a different color and, for example, may be one of a red subpixel, a green subpixel, and a blue subpixel.

According to some embodiments, the plurality of subpixels include a first subpixel PX1, a second subpixel PX2, and a third subpixel PX3. Hereinafter, for convenience of description, a case in which the first subpixel PX1 is a red subpixel, the second subpixel PX2 is a green subpixel, and the third subpixel PX3 is a blue subpixel is described.

The first subpixel PX1, the second subpixel PX2, and the third subpixel PX3 are areas that may emit red light, green light, and blue light, respectively. The display apparatus 1 may display images by using light emitted from the subpixels.

The non-display area NDA is an area that does not display images and may entirely surround the display area DA. A driver or a main voltage line for providing an electrical signal or power to pixel circuits may be arranged in the non-display area NDA. The non-display area NDA may include a pad, which is an area to which an electronic element or a printed circuit board may be electrically connected.

The display area DA may have a polygonal shape including a quadrangle, as shown in FIG. 1. For example, the display area DA may have a rectangular shape with a horizontal length greater than a vertical length, a rectangular shape with a horizontal length less than a vertical length, or a square shape. According to some embodiments, the display area DA may have a circular shape, an elliptical shape, or a polygonal shape such as a triangular shape or a pentagonal shape. In addition, FIG. 1 shows that the display apparatus 1 is a flat-panel display apparatus having a flat shape, but the display apparatus 1 may be implemented in various forms such as a flexible, foldable, or rollable display apparatus.

According to some embodiments, the display apparatus 1 may be an organic light-emitting display apparatus. According to some embodiments, the display apparatus 1 may be an inorganic light-emitting display apparatus or a quantum dot light-emitting display apparatus. For example, an emission layer of a display element included in the display apparatus 1 may include an organic material, an inorganic material, quantum dots, an organic material and quantum dots, an inorganic material and quantum dots, or an organic material, an inorganic material, and quantum dots. Hereinafter, for convenience of description, a case in which the display apparatus 1 is an organic light-emitting display apparatus is mainly described in detail.

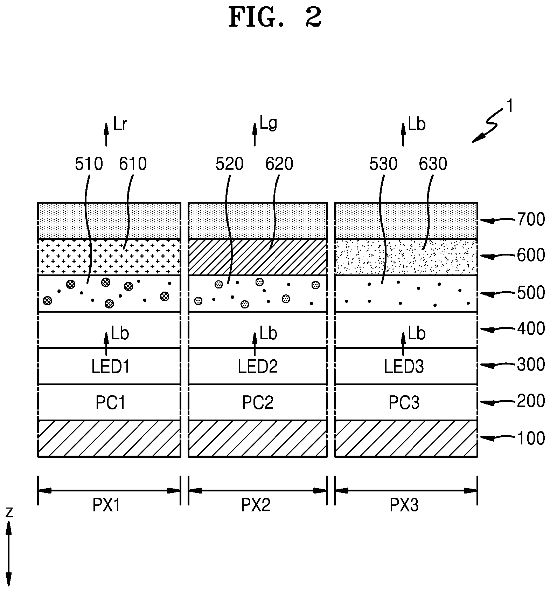

FIG. 2 is a schematic cross-sectional view of the display apparatus 1 according to some embodiments.

Referring to FIG. 2, the display apparatus 1 may include a first substrate 100, a circuit layer 200, a light-emitting diode layer 300, an encapsulation layer 400, a functional layer 500, a color filter layer 600, and a second substrate 700.

The circuit layer 200 may be located on the first substrate 100. The circuit layer 200 may include first, second, and third subpixel circuits PC1, PC2, and PC3, and each of the first to third subpixel circuits PC1, PC2, and PC3 may include a thin-film transistor and/or a capacitor. The first to third subpixel circuits PC1, PC2, and PC3 may be electrically connected to first, second, and third light-emitting diodes LED1, LED2, and LED3 of the light-emitting diode layer 300, respectively.

Each of the first to third light-emitting diodes LED1, LED2, and LED3 may include an organic light-emitting diode including an organic material. According to some embodiments, each of the first to third light-emitting diodes LED1, LED2, and LED3 may include an inorganic light-emitting diode including an inorganic material. The inorganic light-emitting diode may include a PN junction diode including inorganic semiconductor-based materials. When a forward voltage is applied to a PN-junction diode, holes and electrons are injected and energy created by recombination of the holes and the electrons is converted into light energy, and thus, light of a preset color may be emitted. The aforementioned inorganic light-emitting diode may have a width of several to hundreds of micrometers or several to several hundreds of nanometers. In some embodiments, the first to third light-emitting diodes LED1, LED2, and LED3 may include a light-emitting diode including quantum dots. As described above, an emission layer of each of the first to third light-emitting diodes LED1, LED2, and LED3 may include an organic material, include an inorganic material, include quantum dots, include an organic material and quantum dots, or include an inorganic material or quantum dots.

The first to third light-emitting diodes LED1, LED2, and LED3 may emit light of the same color. For example, light (e.g., blue light Lb) emitted from the first to third light-emitting diodes LED1, LED2, and LED3 may pass through the functional layer 500 after passing through the encapsulation layer 400 on the light-emitting diode layer 300. However, one or more embodiments are not limited thereto. According to some embodiments, the first to third light-emitting diodes LED1, LED2, and LED3 may emit light of different colors.

The functional layer 500 may include optical layers that convert the color of the light (e.g., blue light Lb) emitted from the light-emitting diode layer 300 or transmit the light without converting the color of the light. For example, the functional layer 500 may include color conversion layers that convert the light (e.g., blue light Lb) emitted from the light-emitting diode layer 300 to light of another color, and a transmission layer that transmits the light (e.g., blue light Lb) emitted from the light-emitting diode layer 300 without converting the color of the light. The functional layer 500 may include a first color conversion layer 510 corresponding to the first subpixel PX1, a second color conversion layer 520 corresponding to the second subpixel PX2, and a transmission layer 530 corresponding to the third subpixel PX3. The first color conversion layer 510 may convert blue light Lb into red light Lr, and the second color conversion layer 520 may convert the blue light Lb into green light Lg. The transmission layer 530 may pass blue light Lb without converting the color of the blue light Lb.

The color filter layer 600 may be located on the functional layer 500. The color filter layer 600 may include first, second, and third color filters 610, 620, and 630 of different colors. According to some embodiments, the first color filter 610 may be a red color filter, the second color filter 620 may be a green color filter, and the third color filter 630 may be a blue color filter.

Light color-converted by or light transmitted by the functional layer 500 passes through the first to third color filters 610, 620, and 630 such that color purity may be improved. Also, the color filter layer 600 may prevent or significantly reduce external light (e.g., light incident from the outside of the display apparatus 1 toward the display apparatus 1) from being reflected and seen by a user.

The second substrate 700 may be located on the color filter layer 600. The second substrate 700 may be referred to as a light-transmissive base layer. The second substrate 700 may include glass or a light-transmissive organic material. For example, the second substrate 700 may include a light-transmissive organic material such as an acrylic resin.

According to some embodiments, after a light-emitting panel in which the circuit layer 200, the light-emitting diode layer 300, the encapsulation layer 400, and the functional layer 500 are sequentially arranged is formed on the first substrate 100, and a color panel in which the color filter layer 600 is stacked is formed on the second substrate 700, the light-emitting panel and the color panel may be bonded such that the color filter layer 600 and the functional layer 500 face each other.

According to some embodiments, after the functional layer 500 and the color filter layer 600 are sequentially formed over the encapsulation layer 400, the second substrate 700 may be formed by being directly applied and cured on the color filter layer 600.

According to some embodiments, another optical film, for example, an antireflection (AR) film, may be located on the second substrate 700.

The display apparatus 1 having the aforementioned structure may include an electronic apparatus that may display a video or a still image, such as a television, a billboard, a movie theater screen, a monitor, a tablet personal computer (PC), or a laptop computer.

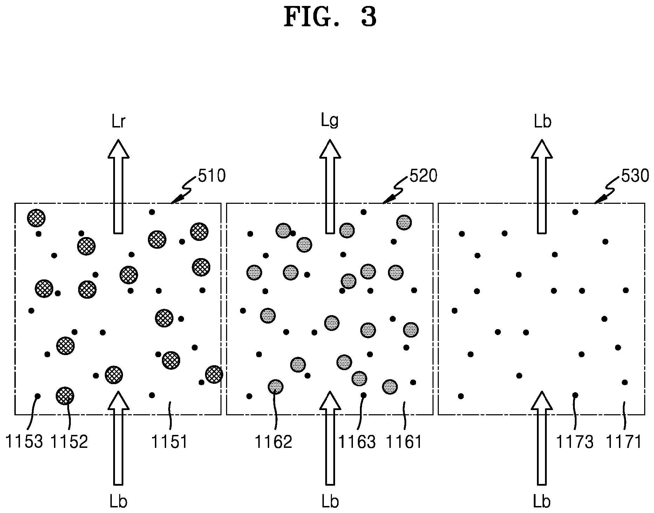

FIG. 3 is a diagram of each optical layer of the functional layer 500 of FIG. 2.

Referring to FIG. 3, the first color conversion layer 510 may convert incident blue light Lb into red light Lr. As shown in FIG. 3, the first color conversion layer 510 may include a first photosensitive polymer 1151, and first quantum dots 1152 and first scattering particles 1153 dispersed in the first photosensitive polymer 1151.

The first quantum dots 1152 may be excited by blue light Lb to isotopically emit red light Lr having a wavelength longer than a wavelength of the blue light Lb. The first photosensitive polymer 1151 may include an organic material having light transmission properties. The first scattering particles 1153 scatter blue light Lb that is not absorbed by the first quantum dots 1152 to cause more first quantum dots 1152 to be excited such that color conversion efficiency may be relatively increased. The first scattering particles 1153 may include, for example, titanium oxide (TiO₂) or metal particles. The first quantum dots 1152 may be selected from among a group II-VI compound, a group III-V compound, a group IV-VI compound, a group IV element, a group IV compound, and any combinations thereof.

The second color conversion layer 520 may convert incident blue light Lb into green light Lg. As shown in FIG. 3, the second color conversion layer 520 may include a second photosensitive polymer 1161, and second quantum dots 1162 and second scattering particles 1163 dispersed in the second photosensitive polymer 1161.

The second quantum dots 1162 may be excited by blue light Lb to isotopically emit green light Lg having a wavelength longer than a wavelength of the blue light Lb. The second photosensitive polymer 1161 may include an organic material having light transmission properties.

The second scattering particles 1163 scatter blue light Lb that is not absorbed by the second quantum dots 1162 to cause more second quantum dots 1162 to be excited such that color conversion efficiency may be increased. The second scattering particles 1163 may include, for example, TiO₂ or metal particles. The second quantum dots 1162 may include a group III-VI compound, a group II-VI compound, a group III-V compound, a group I-III-VI compound, a group IV-VI compound, a group IV element or compound, or any combinations thereof.

According to some embodiments, the first quantum dots 1152 and the second quantum dots 1162 may be the same material. In this case, sizes of the second quantum dots 1162 may be greater than sizes of the first quantum dots 1152.

According to some embodiments, each of a core of a first quantum dot 1152 and a core of a second quantum dot 1162 may be selected from among a group III-VI compound, a group II-VI compound, a group III-V compound, a group I-Ill-VI compound, a group IV-VI compound, a group IV element or compound, or any combinations thereof.

The group II-VI compound may be selected from the group consisting of a binary compound selected from the group consisting of CdSe, CdTe, ZnS, ZnSe, ZnTe, ZnO, HgS, HgSe, HgTe, MgSe, MgS, and any mixtures thereof, a ternary compound selected from the group consisting of AgInS, CulnS, CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and any mixtures thereof, and a quaternary compound selected from the group consisting of HgZnTeS, CdZnSeS, CdZnSeTe, CdZnSTe, CdHgSeS, CdHgSeTe, CdHgSTe, HgZnSeS, HgZnSeTe, HgZnSTe, and any mixtures thereof.

The group III-V compound may be selected from the group consisting of a binary compound selected from the group consisting of GaN, GaP, GaAs, GaSb, AIN, AlP, AlAs, AlSb, InN, InP, InAs, InSb, and any mixtures thereof, a ternary compound selected from the group consisting GaNP, GaNAs, GaNSb, GaPAs, GaPSb, AINP, AlNAs, AlNSb, AlPAs, AlPSb, InGaP, InNP, InNAs, InNSb, InPAs, InPSb, GaAlNP, and any mixtures thereof, and a quaternary compound selected from the group consisting of GaAINAs, GaAINSb, GaAlPAs, GaAlPSb, GalnNP, GalnNAs, GalnNSb, GalnPAs, GalnPSb, InAlNP, InAINAs, InAINSb, InAlPAs, InAlPSb, and any mixtures thereof. In addition, the group III-V compound may further include a group II element. The group III-V compound further including the group II element may include InZnP, InGaZnP, InAlZnP, or the like.

The group III-VI compound may include a binary compound such as GaS, Ga₂S₃, GaSe, Ga₂Se₃, GaTe, InS, InSe, In₂S₃, In₂Se₃, or InTe, a ternary compound such as InGaS₃ or InGaSe₃, or any combinations thereof.

The group I-III-VI compound may include a ternary compound such as AgInS, AgInS₂, AgInSe₂, AgGaS, AgGaS₂, AgGaSe₂, CulnS, CuInS₂, CuInSe₂, CuGaS₂, CuGaSe₂, CuGaO₂, AgGaO₂, or AgAlO₂, a quaternary compound such as AgInGaS₂ or AgInGaSe₂, or any combinations thereof. The group IV-VI compound may be selected from among a binary compound selected from the group consisting of SnS, SnSe, SnTe, PbS, PbSe, PbTe, and any mixtures thereof, a ternary compound selected from the group consisting of SnSeS, SnSeTe, SnSTe, PbSeS, PbSeTe, PbSTe, SnPbS, SnPbSe, SnPbTe, and any mixtures thereof, and a quaternary compound selected from the group consisting of SnPbSSe, SnPbSeTe, SnPbSTe, and any mixtures thereof. The group IV element may be selected from the group consisting of silicon (Si), germanium (Ge), and any mixtures thereof. The group IV compound may be a binary compound selected from the group consisting of SiC, SiGe, and any mixtures thereof.

In this case, the binary compound, the ternary compound, or the quaternary compound may be present in particles at a uniform concentration or may be present in the same particle divided into two states where concentration distributions are partially different. That is, the above chemical formulas refer to types of elements included in compounds, and element ratios in the compounds may be different. For example, AgInGaS₂ may refer to AgInₓGa₁₋ₓS₂ (x is a real number between 0 and 1).

Also, each of the first quantum dot 1152 and the second quantum dot 1162 may have a core-shell structure in which one quantum dot surrounds another quantum dot. An interface between a core and a shell may have a concentration gradient in which the concentration of elements present in the shell decreases toward the center.

In some embodiments, each of the first quantum dot 1152 and the second quantum dot 1162 may have the aforementioned core-shell structure including a core including nanocrystals and a shell surrounding the core. The shell of the quantum dot may function as a protective layer for maintaining semiconductor characteristics by preventing or reducing chemical denaturation of the core and/or a charging layer for imparting electrophoretic characteristics to the quantum dot. The shell may include a single layer or a multilayer. An interface between a core and a shell may have a concentration gradient in which the concentration of elements present in the shell decreases toward the center. Examples of the shell of the quantum dot may include an oxide of a metal or a non-metal, a semiconductor compound, and a combination thereof.

Examples of the oxide of the metal or the non-metal may include a binary compound such as SiOₓ, Al₂O₃, TiO₂, ZnOₓ, MnO, Mn₂O₃, Mn₃O₄, CuO, FeO, Fe₂O₃, Fe₃O₄, CoO, Co₃O₄, or NiO and a ternary compound such as MgAl₂O₄, CoFe₂O₄, NiFe₂O₄, or CoMn₂O₄ but are not limited thereto.

Examples of the semiconductor compound may include CdS, CdSe, CdTe, ZnS, ZnSe, ZnTe, ZnSeS, ZnTeS, GaAs, GaP, GaS, GaSe, AgGaS, AgGaS₂, GaSb, HgS, HgSe, HgTe, InAs, InP, InGaP, InSb, AlAs, AlP, and AlSb but are not limited thereto.

Each element included in a multi-element compound such as the binary compound or the ternary compound may be present in particles at a uniform concentration or a non-uniform concentration. That is, the above chemical formulas refer to types of elements included in compounds, and element ratios in the compounds may be different.

According to some embodiments, each of the first quantum dot 1152 and the second quantum dot 1162 may have a full width at half maximum (FWHM) of an emission wavelength spectrum of about 45 nm or less, preferably about 40 nm or less, more preferably about 30 nm or less, and color purity and color reproducibility may be improved within this range. Also, because light emitted through a quantum dot is emitted in all directions, an optical viewing angle may be improved.

Also, the shape of each of the first quantum dot 1152 and the second quantum dot 1162 is not particularly limited to those commonly used in the art, but more specifically, spherical, pyramidal, multi-arm, or cubic nanoparticles, nanotubes, nanowires, nanofibers, nanoplate-shaped particles, etc. may be used.

Each of the first quantum dot 1152 and the second quantum dot 1162 may adjust the color of light emitted depending on a particle size, and accordingly, the first quantum dot 1152 and the second quantum dot 1162 may have various emission colors such as blue, red, and green.

The transmission layer 530 may transmit blue light Lb incident on the transmission layer 530 without converting the blue light Lb. As shown in FIG. 3, the transmission layer 530 may include a third photosensitive polymer 1171 in which third scattering particles 1173 are dispersed. For example, the third photosensitive polymer 1171 may include, for example, an organic material having light transmission properties, such as a silicon resin or an epoxy resin, and the third photosensitive polymer 1171 and the first and second photosensitive polymers 1151 and 1161 may include the same material. The third scattering particles 1173 may scatter and emit blue light Lb, and the third scattering particles 1173 and the first and second scattering particles 1153 and 1163 may include the same material.

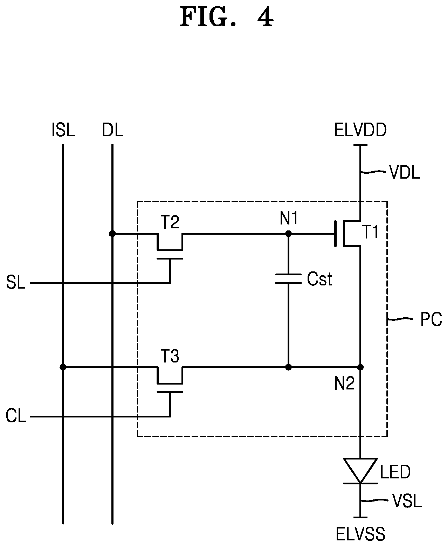

FIG. 4 is an equivalent circuit diagram of a light-emitting diode LED included in a display apparatus and a subpixel circuit PC electrically connected to the light-emitting diode LED, according to some embodiments. The subpixel circuit PC shown in FIG. 4 may correspond to each of the first to third subpixel circuits PC1, PC2, and PC3 described above with reference to FIG. 2, and the light-emitting diode LED of FIG. 4 may correspond to each of the first to third light-emitting diodes LED1, LED2, and LED3.

Referring to FIG. 4, a light-emitting diode, for example, a subpixel electrode (e.g., an anode) of the light-emitting diode LED, may be connected to the subpixel circuit PC, and an opposite electrode (e.g., a cathode) of the light-emitting diode LED may be connected to a common voltage line VSL or an auxiliary wire that provides a common voltage ELVSS. The light-emitting diode LED may emit light with a luminance corresponding to the amount of current supplied from the subpixel circuit PC.

The subpixel circuit PC may be configured to control, in response to a data signal, the amount of current flowing from a driving voltage line VDL to the common voltage line VSL via the light-emitting diode LED. The subpixel circuit PC may include a first thin-film transistor T1, a second thin-film transistor T2, a third thin-film transistor T3, and a storage capacitor Cst.

Each of the first thin-film transistor T1, the second thin-film transistor T2, and third thin-film transistor T3 may include an oxide semiconductor transistor including a semiconductor layer including an oxide semiconductor, or may include a silicon semiconductor transistor including a semiconductor layer including polysilicon. According to the type of thin-film transistor, a first electrode may be one of a source electrode and a drain electrode, and a second electrode may be the other of the source and drain electrodes.

The first thin-film transistor T1 may be a driving thin-film transistor. A first electrode of the first thin-film transistor T1 may be connected to a driving voltage line VDL through which the driving voltage ELVDD is supplied, and a second electrode of the first thin-film transistor T1 may be connected to the subpixel electrode of the light-emitting diode LED. A gate electrode of the first thin-film transistor T1 may be connected to a first node N1. The first thin-film transistor T1 may be configured to control, in response to a voltage of the first node N1, the amount of current flowing from the driving voltage line VDL to the light-emitting diode LED.

The second thin-film transistor T2 may include a switching thin-film transistor. A first electrode of the second thin-film transistor T2 may be connected to a data line DL, and a second electrode of the second thin-film transistor T2 may be connected to the first node N1. A gate electrode of the second thin-film transistor T2 may be connected to a scan line SL. The second thin-film transistor T2 may be turned on when a scan signal is supplied through the scan line SL, and may be configured to electrically connect the data line DL to the first node N1.

The third thin-film transistor T3 may be an initialization thin-film transistor and/or a sensing thin-film transistor. A first electrode of the third thin-film transistor T3 may be connected to a second node N2, and a second electrode of the third thin-film transistor T3 may be connected to a sensing line ISL. A gate electrode of the third thin-film transistor T3 may be connected to a control line CL.

The storage capacitor Cst may be connected between the first node N1 and the second node N2. For example, a first capacitor electrode of the storage capacitor Cst may be connected to the gate electrode of the first thin-film transistor T1, and a second capacitor electrode of the storage capacitor Cst may be connected to the subpixel electrode of the light-emitting diode LED.

Although FIG. 4 illustrates that the first thin-film transistor T1, the second thin-film transistor T2, and the third thin-film transistor T3 are n-channel metal-oxide-semiconductor field-effect transistors (MOSFETs) (NMOSs), one or more embodiments are not limited thereto. For example, at least one of the first thin-film transistor T1, the second thin-film transistor T2, or the third thin-film transistor T3 may be formed as a p-channel MOSFET (PMOS).

Although three thin-film transistors are shown in FIG. 4, one or more embodiments are not limited thereto. The subpixel circuit PC may include four or more thin-film transistors.

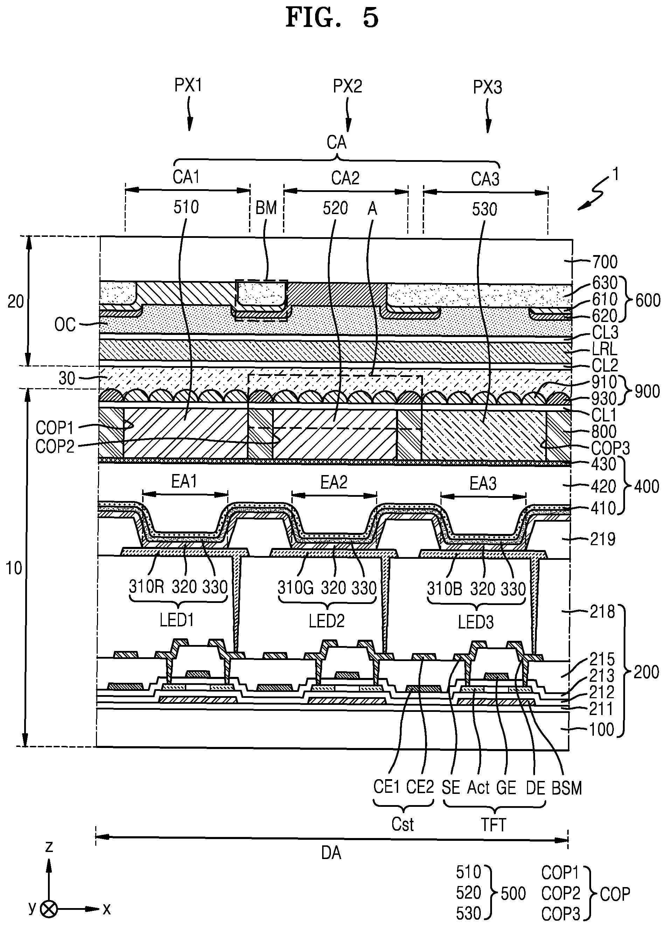

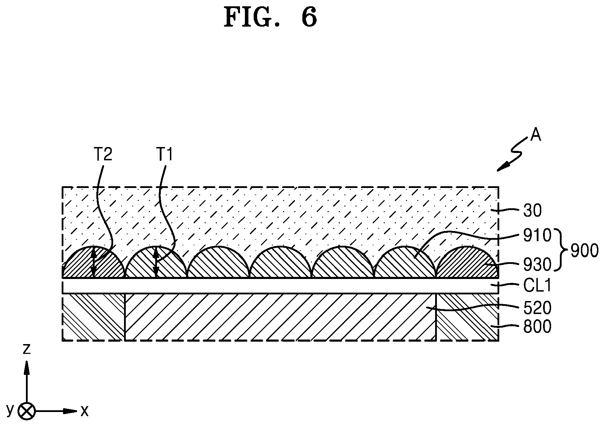

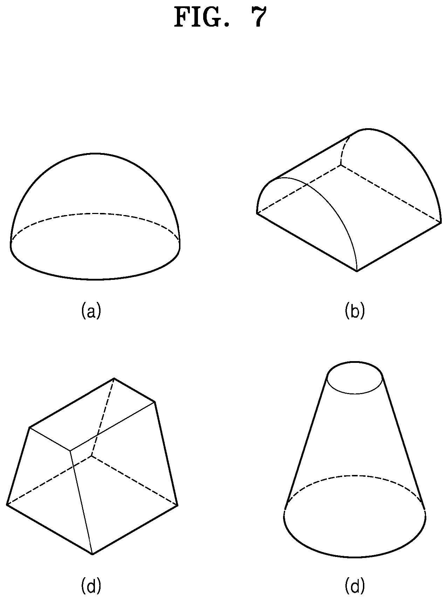

FIG. 5 is a schematic cross-sectional view of the display apparatus 1 according to some embodiments. FIG. 6 is an enlarged view of a region "A" of FIG. 5. FIG. 7 is a diagram illustrating an example of a shape of a lens.

Referring to FIGS. 5 to 7, the display apparatus 1 may include a light-emitting panel 10 and a color panel 20. The display apparatus 1 may further include a filling layer 30 between the light-emitting panel 10 and the color panel 20. The display apparatus 1 may be formed by separately forming the light-emitting panel 10 and the color panel 20 and then combining the light-emitting panel 10 with the color panel 20. According to some embodiments, the light-emitting panel 10, the filling layer 30, and the color panel 20 may be stacked in a thickness direction (e.g., a z-direction).

The light-emitting panel 10 may include the first substrate 100, the circuit layer 200 on the first substrate 100, the light-emitting diode layer 300 on the circuit layer 200, the encapsulation layer 400 on the light-emitting diode layer 300, the functional layer 500 on the encapsulation layer 400, and a plurality of lenses 900 on the functional layer 500. The color panel 20 may include the second substrate 700 and the color filter layer 600 on the second substrate 700. According to some embodiments, the color panel 20 may further include a low refractive layer LRL.

The circuit layer 200 may include a plurality of subpixel circuits corresponding to the first to third subpixels PX1, PX2, and PX3, which have been described with reference to FIG. 1, and the subpixel circuit may include a plurality of thin-film transistors TFT and a storage capacitor Cst as described with reference to FIG. 4. For example, a thin-film transistor TFT may include a driving thin-film transistor T1 (see FIG. 4).

A stacked structure of the light-emitting panel 10 is described below in detail.

The first substrate 100 may include a glass material, a ceramic material, a metal material, or a flexible or bendable material. When the first substrate 100 is flexible or bendable, the first substrate 100 may include a polymer resin such as polyethersulfone, polyacrylate, polyetherimide, polyethylene naphthalate, polyethylene terephthalate, polyphenylene sulfide, polyarylate, polyimide, polycarbonate, or cellulose acetate propionate. The first substrate 100 may have a single-layer or multilayer structure of the material described above, and when the first substrate 100 has a multilayer structure, the first substrate 100 may further include an inorganic layer. According to some embodiments, the first substrate 100 may have a structure of an organic material/inorganic material/organic material.

The circuit layer 200 may be located on the first substrate 100. The circuit layer 200 may include the thin-film transistor TFT and the storage capacitor Cst. According to some embodiments, the circuit layer 200 may further include a first buffer layer 211, a second buffer layer 212, a gate insulating layer 213, an interlayer insulating layer 215, and a planarization layer 218.

The first buffer layer 211 may be located on the first substrate 100. The first buffer layer 211 may prevent or reduce the penetration of foreign materials, moisture, contaminants, or external air from the bottom of the first substrate 100 and may provide a flat surface on the first substrate 100. The first buffer layer 211 may include, for example, an inorganic insulating layer such as silicon oxide, silicon oxynitride, and silicon nitride and may have a single-layer or multilayer structure including the aforementioned material.

A barrier layer may be further included between the first substrate 100 and the first buffer layer 211. The barrier layer may prevent or significantly reduce the penetration of impurities from the first substrate 100 or the like into a semiconductor layer Act. The barrier layer may include an inorganic material such as oxide or nitride, include an organic material, or include an organic-inorganic composite, and may include a single-layer or multilayer structure of an inorganic material and an organic material.

A bias electrode BSM may be located on the first buffer layer 211 to correspond to the thin-film transistor TFT. According to some embodiments, a voltage may be applied to the bias electrode BSM. Also, the bias electrode BSM may prevent or reduce external light reaching the semiconductor layer Act. Accordingly, characteristics of the thin-film transistor TFT may be stabilized. In addition, the bias electrode BSM may be omitted when necessary.

The second buffer layer 212 may be located on the first buffer layer 211. According to some embodiments, the second buffer layer 212 may be located on the bias electrode BSM. The second buffer layer 212 may include, for example, an inorganic insulating material such as silicon oxide, silicon oxynitride, and silicon nitride and may have a single-layer or multilayer structure including the aforementioned material.

The thin-film transistor TFT may be located on the first buffer layer 211. The thin-film transistor TFT may be located on the second buffer layer 212. The thin-film transistor TFT may include the semiconductor layer Act, a gate electrode GE, a source electrode SE, and a drain electrode DE. The thin-film transistor TFT may be connected to and drive the first to third light-emitting diodes LED1, LED2, and LED3.

The semiconductor layer Act may be located on the second buffer layer 212. The semiconductor layer Act may include, for example, amorphous silicon or polysilicon. According to some embodiments, the semiconductor layer Act may include an oxide of at least one material selected from the group consisting of indium (In), gallium (Ga), tin (Sn), zirconium (Zr), vanadium (V), hafnium (Hf), cadmium (Cd), germanium (Ge), chromium (Cr), titanium (Ti), aluminum (Al), cesium (Cs), cerium (Ce), and zinc (Zn). In some embodiments, the semiconductor layer Act may include a Zn oxide-based material, such as a Zn oxide, an In-Zn oxide, and a Ga-In-Zn oxide. According to some embodiments, the semiconductor layer Act may be In-Ga-Zn-O (IGZO) semiconductor, In-Sn-Zn-O (ITZO) semiconductor, or In-Ga-Sn-Zn-O (IGTZO) semiconductor including a metal such as In, Ga, or Sn in a zinc oxide. The semiconductor layer Act may include a channel region, and a source region and a drain region, which are at both sides of the channel region.

In order to secure insulation between the semiconductor layer Act and the gate electrode GE, the gate insulating layer 213 may be between the semiconductor layer Act and the gate electrode GE. The gate insulating layer 213 may also include, for example, an inorganic material such as silicon oxide, silicon nitride, and/or silicon oxynitride.

The gate electrode GE may be located on the semiconductor layer Act with the gate insulating layer 213 therebetween. The gate electrode GE may at least partially overlap the semiconductor layer Act. The gate electrode GE may include, for example, molybdenum (Mo), Al, copper (Cu), Ti, or the like. The gate electrode GE may have a single layer or a multilayer. For example, the gate electrode GE may be a single Mo layer.

The storage capacitor Cst may be located on the gate insulating layer 213. The storage capacitor Cst may include a first electrode CE1 and a second electrode CE2. The second electrode CE2 of the storage capacitor Cst may overlap the first electrode CE1 with the interlayer insulating layer 215 therebetween, and the first and second electrodes CE1 and CE2 may form the storage capacitor Cst. In this case, the interlayer insulating layer 215 may function as a dielectric layer of the storage capacitor Cst. The first electrode CE1 of the storage capacitor Cst and the gate electrode GE may be arranged on the same layer. The first electrode CE1 and the gate electrode GE may include the same material. The first electrode CE1 of the storage capacitor Cst and the gate electrode GE may be arranged on the same layer.

Although FIG. 5 illustrates that the gate electrode GE of the thin-film transistor TFT and the first electrode CE1 of the storage capacitor Cst are separately arranged, the storage capacitor Cst may overlap the thin-film transistor TFT. In this case, the gate electrode GE of the thin-film transistor TFT may function as the first electrode CE1 of the storage capacitor Cst.

The interlayer insulating layer 215 may be located on the gate electrode GE and the storage capacitor Cst. The interlayer insulating layer 215 may be arranged to cover the gate electrode GE and the storage capacitor Cst. The interlayer insulating layer 215 may include, for example, silicon oxide, silicon nitride, silicon oxynitride, aluminum oxide, titanium oxide, tantalum oxide, hafnium oxide, or zinc oxide.

The second electrode CE2, the source electrode SE, and the drain electrode DE may be located on the interlayer insulating layer 215. Each of the second electrode CE2, the source electrode SE, and the drain electrode DE may include a conductive material including Mo, Al, Cu, Ti, or the like, and may include a multilayer or single layer including the aforementioned material. For example, each of the second electrode CE2, the source electrode SE, and the drain electrode DE may have a multilayer structure of Ti/Al/Ti. The source electrode SE and the drain electrode DE may be respectively connected to the source region and the drain region of the semiconductor layer Act through a contact hole.

The planarization layer 218 may be located on the second electrode CE2, the source electrode SE, and the drain electrode DE. The planarization layer 218 may include a single layer or a multilayer including an organic material layer and may provide a flat upper surface. The planarization layer 218 may include, for example, a general-purpose polymer such as benzocyclobutene (BCB), polyimide, hexamethyldisiloxane (HMDSO), poly(methyl methacrylate) (PMMA), or polystyrene (PS), a polymer derivative having a phenol-based group, an acrylic polymer, an imide-based polymer, an aryl-ether-based polymer, an amide-based polymer, a fluorine-based polymer, a p-xylene-based polymer, a vinyl alcohol-based polymer, and any blends thereof.

The first light-emitting diode LED1, the second light-emitting diode LED2, and the third light-emitting diode LED3 may be located on the circuit layer 200. The first light-emitting diode LED1, the second light-emitting diode LED2, and the third light-emitting diode LED3 may be located on the planarization layer 218. The first light-emitting diode LED1, the second light-emitting diode LED2, and the third light-emitting diode LED3 may include a first pixel electrode 310R, a second pixel electrode 310G, and a third pixel electrode 310B, respectively. According to some embodiments, the first light-emitting diode LED1, the second light-emitting diode LED2, and the third light-emitting diode LED3 may commonly include an emission layer 320 and an opposite electrode 330.

The first pixel electrode 310R, the second pixel electrode 310G, and the third pixel electrode 310B may include a (semi-)transmissive electrode or a reflective electrode. According to some embodiments, each of the first pixel electrode 310R, the second pixel electrode 310G, and the third pixel electrode 310B may include a reflective layer and a transparent or semi-transparent electrode layer formed on the reflective layer, wherein the reflective layer may include silver (Ag), magnesium (Mg), Al, platinum (Pt), palladium (Pd), gold (Au), nickel (Ni), neodymium (Nd), iridium (Ir), Cr, and any compounds thereof. The transparent or semi-transparent electrode layer may include at least one selected from the group consisting of indium tin oxide (ITO), indium zinc oxide (IZO), zinc oxide, indium oxide, indium gallium oxide (IGO), and aluminum zinc oxide (AZO). According to some embodiments, each of the first pixel electrode 310R, the second pixel electrode 310G, and the third pixel electrode 310B may have a structure of ITO/Ag/ITO.

A pixel-defining layer 219 may be located on the planarization layer 218. The pixel-defining layer 219 may include openings that expose the first pixel electrode 310R, the second pixel electrode 310G, and the third pixel electrode 310B, respectively. The pixel-defining layer 219 may cover edges of the first pixel electrode 310R, the second pixel electrode 310G, and the third pixel electrode 310B.

The pixel-defining layer 219 may include, for example, one or more organic insulating materials selected from the group consisting of polyimide, polyamide, an acrylic resin, BCB, and a phenol-based resin, and may be formed by a method such as spin coating.

Each of the emission layers 320 of first light-emitting diode LED1, the second light-emitting diode LED2, and the third light-emitting diode LED3 may include an organic material including a fluorescent or phosphorescent material that emits green, red, blue, or white light. The emission layer 320 may be a low-molecular-weight organic material or a polymer organic material, and a functional layer, such as a hole transport layer (HTL), a hole injection layer (HIL), an electron transport layer (ETL), and an electron injection layer (ElL), may be optionally further arranged under and over the emission layer 320.

FIG. 5 illustrates that the emission layer 320 is integrally formed as a single body across the first pixel electrode 310R, the second pixel electrode 310G, and the third pixel electrode 310B but is not limited thereto. The emission layer 320 may be arranged to correspond to each of the first pixel electrode 310R, the second pixel electrode 310G, and the third pixel electrode 310B. Various modifications may be made.

According to some embodiments, the emission layer 320 may include a first color emission layer. The first color emission layer may be integrally formed as a single body across the first pixel electrode 310R, the second pixel electrode 310G, and the third pixel electrode 310B, and may be patterned to correspond to each of the first pixel electrode 310R, the second pixel electrode 310G, and the third pixel electrode 310B when necessary. The first color emission layer may emit light in a first wavelength band, for example, may emit blue light. According to some embodiments, the emission layer 320 may emit light having a wavelength of about 450 nm to about 495 nm.

The opposite electrode 330 may be located on the emission layer 320 to correspond to the first pixel electrode 310R, the second pixel electrode 310G, and the third pixel electrode 310B. The opposite electrode 330 may be integrally formed as a single body in a plurality of organic light-emitting elements. According to some embodiments, the opposite electrode 330 may be a transparent or semi-transparent electrode and may include a metal thin film that has a small work function and includes lithium (Li), calcium (Ca), lithium fluoride (LiF)/Ca, LiF/Al, Al, Ag, Mg, or any compounds thereof. Also, a transparent conductive oxide (TCO) layer including ITO, IZO, ZnO, or In₂O₃ may be further located on the metal thin film.

According to some embodiments, one light-emitting diode LED, for example, each of the first light-emitting diode LED1, the second light-emitting diode LED2, and the third light-emitting diode LED3 may include a plurality of emission layers 320, which are stacked in order. For example, each of the first light-emitting diode LED1, the second light-emitting diode LED2, and the third light-emitting diode LED3 may include a first emission layer and a second emission layer, which are stacked in order. A negative charge generation layer and a positive charge generation layer may be between adjacent emission layers 320. For example, the negative charge generation layer and the positive charge generation layer may be between the first emission layer and the second emission layer. In this case, in one light-emitting diode LED, a pixel electrode, a first emission layer, a negative charge generation layer, a positive charge generation layer, a second emission layer, and the opposite electrode 330 may be stacked in order. For example, in the first light-emitting diode LED1, the first pixel electrode 310R, a first emission layer, a negative charge generation layer, a positive charge generation layer, a second emission layer, and the opposite electrode 330 may be stacked in order. For example, the negative charge generation layer may supply electrons. The negative charge generation layer may include an n-type charge generation layer. The negative charge generation layer may include a host and a dopant. The host may include an organic material. The dopant may include a metal material. The positive charge generation layer may include a p-type charge generation layer. The positive charge generation layer may supply holes. The positive charge generation layer may include a host and a dopant. The host may include an organic material. The dopant may include a metal material.

First to third emission areas EA1, EA2, and EA3 may correspond to the first to third subpixels PX1, PX2, and PX3, respectively. The first to third emission areas EA1, EA2, and EA3 may be areas where light generated from the first to third light-emitting diodes LED1, LED2, and LED3 is emitted to the outside, respectively. According to some embodiments, the first emission area EA1 may be defined as a portion of the first pixel electrode 310R, which is exposed by an opening of the pixel-defining layer 219. According to some embodiments, the second emission area EA2 may be defined as a portion of the second pixel electrode 310G, which is exposed by an opening of the pixel-defining layer 219. According to some embodiments, the third emission area EA3 may be defined as a portion of the third pixel electrode 310B, which is exposed by an opening of the pixel-defining layer 219.

A spacer for preventing or reducing masking defects may be further included on the pixel-defining layer 219. According to some embodiments, the spacer may be integrally formed as a single body with the pixel-defining layer 219. For example, the spacer and the pixel-defining layer 219 may be simultaneously formed in the same process by using a half-tone mask process.

The first light-emitting diode LED1, the second light-emitting diode LED2, and the third light-emitting diode LED3 may be easily damaged by moisture or oxygen from the outside and may thus be covered and protected by the encapsulation layer 400. The encapsulation layer 400 may cover the display area DA and extend to the outside of the display area DA. The encapsulation layer 400 may include at least one organic encapsulation layer and at least one inorganic encapsulation layer. For example, the encapsulation layer 400 may include a first inorganic encapsulation layer 410, an organic encapsulation layer 420, and a second inorganic encapsulation layer 430.

The first inorganic encapsulation layer 410 is formed along a structure thereunder and may thus not have a flat upper surface. The organic encapsulation layer 420 may cover the first inorganic encapsulation layer 410. Unlike the first inorganic encapsulation layer 410, an upper surface of the organic encapsulation layer 420 may be substantially flat.

Each of the first inorganic encapsulation layer 410 and the second inorganic encapsulation layer 430 may include one or more inorganic materials from among aluminum oxide, titanium oxide, tantalum oxide, hafnium oxide, zinc oxide, silicon oxide, silicon nitride, and silicon oxynitride. The organic encapsulation layer 420 may include a polymer-based material. The polymer-based material may include an acrylic resin, an epoxy-based resin, polyimide, and polyethylene. According to some embodiments, the organic encapsulation layer 420 may include acrylate. The organic encapsulation layer 420 may be formed by hardening a monomer or coating a polymer.

Even when cracks occur in the encapsulation layer 400, the aforementioned multilayer structure of the encapsulation layer 400 may prevent or reduce these cracks being connected between the first inorganic encapsulation layer 410 and the organic encapsulation layer 420 or between the organic encapsulation layer 420 and the second inorganic encapsulation layer 430. Thus, the formation of a path through which external moisture, oxygen, or the like penetrates the display area DA may be prevented or significantly reduced.

In some embodiments, other layers such as a capping layer may be between the first inorganic encapsulation layer 410 and the opposite electrode 330.

A bank layer 800 may be located on the encapsulation layer 400. The bank layer 800 may include an organic material. When necessary, the bank layer 800 may include a light-shielding material to function as a light-shielding layer. For example, the light-shielding material may include at least one of a black pigment, a black dye, black particles, or metal particles.

In the bank layer 800, openings COP may be defined as partition walls. The openings COP may overlap the first to third emission areas EA1, EA2, and EA3, respectively. The openings COP of the bank layer 800 may include a first opening COP1, a second opening COP2, and a third opening COP3. That is, in the bank layer 800, the first opening COP1 overlapping the first emission area EA1, the second opening COP2 overlapping the second emission area EA2, and the third opening COP3 overlapping the third emission area EA3 may be defined.

The functional layer 500 may fill the openings COP of the bank layer 800. According to some embodiments, the functional layer 500 may include at least one of quantum dots or scattering particles. According to some embodiments, the functional layer 500 may include the first color conversion layer 510, the second color conversion layer 520, and the transmission layer 530. The first color conversion layer 510, the second color conversion layer 520, and the transmission layer 530 may be divided by the partition walls of the bank layer 800.

The first color conversion layer 510 may correspond to the first emission area EA1. The first color conversion layer 510 may overlap the first emission area EA1. The first color conversion layer 510 may fill the first opening COP1 of the bank layer 800. The first color conversion layer 510 may be arranged in a direction (e.g., the z-direction) of light output from the first light-emitting diode LED1.

The first color conversion layer 510 may convert light in a first wavelength band generated from the emission layer 320 on the first pixel electrode 310R into light in a second wavelength band. According to some embodiments, the first color conversion layer 510 may convert blue light into red light. For example, when light having a wavelength of about 450 nm to about 495 nm is generated in the emission layer 320 on the first pixel electrode 310R, the first color conversion layer 510 may convert the generated light into light having a wavelength of about 630 nm to about 780 nm. Accordingly, in the first subpixel PX1, the light having a wavelength of about 630 nm to about 780 nm may be emitted to the outside through the second substrate 700.

The second color conversion layer 520 may correspond to the second emission area EA2. The second color conversion layer 520 may overlap the second emission area EA2. The second color conversion layer 520 may fill the second opening COP2 of the bank layer 800. The second color conversion layer 520 may be arranged in a direction (e.g., the z-direction) of light output from the second light-emitting diode LED2.

The second color conversion layer 520 may convert light in a first wavelength band generated from the emission layer 320 on the second pixel electrode 310G into light in a third wavelength band. For example, the second color conversion layer 520 may convert blue light into green light. For example, when light having a wavelength of about 450 nm to about 495 nm is generated in the emission layer 320 on the second pixel electrode 310G, the second color conversion layer 520 may convert the generated light into light having a wavelength of about 495 nm to about 570 nm. Accordingly, in the second subpixel PX2, the light having a wavelength of about 495 nm to about 570 nm may be emitted to the outside through the second substrate 700.

The transmission layer 530 may correspond to the third emission area EA3. The transmission layer 530 may overlap the third emission area EA3. The transmission layer 530 may fill the third opening COP3 of the bank layer 800. The transmission layer 530 may be arranged in a direction (e.g., the z-direction) of light output from the third light-emitting diode LED3.

The transmission layer 530 may emit light generated from the emission layer 320 on the third pixel electrode 310B to the outside without wavelength conversion. For example, the transmission layer 530 may pass blue light without converting the color of the blue light. For example, when light having a wavelength of about 450 nm to about 495 nm is generated in the emission layer 320 on the third pixel electrode 310B, the transmission layer 530 may emit the light to the outside without wavelength conversion.

A first capping layer CL1 may be located on the functional layer 500 and the bank layer 800. The first capping layer CL1 may be arranged over the functional layer 500. According to some embodiments, the first capping layer CL1 may be between the functional layer 500 and the plurality of lenses 900 to be described below.

The first capping layer CL1 may protect the functional layer 500 and the bank layer 800. The first capping layer CL1 may prevent or reduce impurities such as moisture and/or air from penetrating from the outside and damaging or contaminating the functional layer 500 and/or the bank layer 800. The first capping layer CL1 may include an inorganic material. According to some embodiments, the first capping layer CL1 may be omitted when necessary.

According to some embodiments, it is shown that only the first capping layer CL1 is located directly on the bank layer 800 but is not limited thereto. According to some embodiments, a light-shielding layer including a light-shielding material may be further provided between the bank layer 800 and the first capping layer CL1. The light-shielding layer may be located on the bank layer 800 and overlap the bank layer 800 in a direction (e.g., the z-direction) perpendicular to the first substrate 100. The light-shielding layer may be located on the bank layer 800 and overlap a portion of the functional layer 500 but may not overlap other portions of the functional layer 500. The light-shielding layer may have an opening that overlaps the functional layer 500. The opening of the light-shielding layer may overlap a portion of the functional layer 500.

The plurality of lenses 900 may be arranged over the functional layer 500. According to some embodiments, the plurality of lenses 900 may be located on the first capping layer CL1. The plurality of lenses 900 may be between the functional layer 500 and the color panel 20. The plurality of lenses 900 may be between the functional layer 500 and the color filter layer 600. The plurality of lenses 900 may be between the functional layer 500 and the low refractive layer LRL. The plurality of lenses 900 may be between the functional layer 500 and the filling layer 30. The plurality of lenses 900 may be between the first capping layer CL1 and the filling layer 30.

The plurality of lenses 900 may have a refractive index higher than a refractive index of the functional layer 500. The plurality of lenses 900 may have a refractive index higher than a refractive index of the first capping layer CL1. The refractive index of the plurality of lenses 900 may range, for example, from about 1.65 to about 2.0. A width of each of the plurality of lenses 900 may range, for example, from about 0.5 µm to about 10 µm. In the present specification, the width of each of the plurality of lenses 900 may be defined as the maximum width of a lens.

Each of the plurality of lenses 900 may include a light-transmissive inorganic material and/or an organic material. For example, the organic material included in each of the plurality of lenses 900 may include a photocurable material. For example, the organic material included in each of the plurality of lenses 900 may include acrylate, epoxy, and/or epoxy acrylate. For example, each of the plurality of lenses 900 include metal oxide particles or metal nitride particles, such as zinc oxide, titanium oxide, zirconium oxide, niobium oxide, tantalum oxide, tin oxide, nickel oxide, indium nitride, and/or gallium nitride.

In FIGS. 5 and 6, it is shown that the plurality of lenses 900 have a hemispherical shape, but the shape is not limited thereto and may be variously modified. For example, the shape of the plurality of lenses 900 may be a hemispherical shape as shown in (a) of FIG. 7, a semi-cylindrical shape as shown in (b) of FIG. 7, a truncated pyramidal shape as shown in (c) of FIG. 7, or a truncated cone shape as shown in (d) of FIG. 7.

As shown in FIGS. 5 and 6, the plurality of lenses 900 may include a first lens 910 arranged to overlap the functional layer 500, and a second lens 930 arranged to overlap a partition wall of the bank layer 800. The first lens 910 and the second lens 930 may be formed in the same process operation and include the same material. Accordingly, the first lens 910 and the second lens 930 may have the same refractive index. The first lens 910 and the second lens 930 may be formed in the same process operation and arranged on the same layer.

A plurality of first lenses 910 may be arranged in an area overlapping the functional layer 500. The plurality of first lenses 910 may be arranged in areas overlapping the openings COP of the bank layer 800, respectively. The plurality of first lenses 910 may be provided in areas overlapping the first color conversion layer 510, the second color conversion layer 520, and the transmission layer 530, respectively. The first lenses 910 may change a path of light output from the functional layer 500 by overlapping the functional layer 500, such that light output efficiency may be improved. A set of the first lenses 910 may be referred to as a light collection layer.

The second lens 930 may overlap the partition wall of the bank layer 800. Second lenses 930 may overlap the bank layer 800 that is between the first color conversion layer 510 and the second color conversion layer 520, between the second color conversion layer 520 and the transmission layer 530, or between the first color conversion layer 510 and the transmission layer 530.

The second lens 930 is arranged by overlapping the partition wall of the bank layer 800 and may thus function as a spacer that maintains a gap between the light-emitting panel 10 and the color panel 20. In the present specification, the second lenses 930 may be referred to as spacers.

According to one or more embodiments, by forming the plurality of lenses 900 that may function as spacers in an existing spacer manufacturing operation, a spacer and a lens that improves the light output efficiency may be simultaneously formed without adding a separate mask, and thus, there are economic benefits to the process.

The first lens 910 and the second lens 930 may have the same shape. For example, when the first lens 910 is hemispherical, the second lens 930 may also be hemispherical. For example, when the first lens 910 is a semi-cylindrical, the second lens 930 may also be semi-cylindrical. As shown in FIG. 6, a thickness T1 of the first lens 910 and a thickness T2 of the second lens 930 may be substantially the same. However, the thickness T1 of the first lens 910 and the thickness T2 of the second lens 930 are not limited to being the same, and according to embodiments, the thickness T1 of the first lens 910 and the thickness T2 of the second lens 930 may vary. In the present specification, a thickness may be defined as a vertical thickness according to a direction (e.g., the z-direction) perpendicular to the first substrate 100.

According to some embodiments, a pair of lenses 900 adjacent to each other among the plurality of lenses 900 may be in contact with each other. The plurality of first lenses 910 overlapping one opening COP of the bank layer 800 may be arranged to be in contact with each other. For example, as shown in FIG. 6, the plurality of first lenses 910 overlapping the second color conversion layer 520 may be arranged to be in contact with each other. According to some embodiments, the first lens 910 and the second lens 930 may be arranged to be in contact with each other. According to some embodiments, a distance between centers of the pair of lenses 900 adjacent to each other among the plurality of lenses 900 may be the same as a width of one lens 900. In this case, a distance between the pair of lenses 900 adjacent to each other may range from about 0.5 µm to about 10 µm. However, an arrangement of the plurality of lenses 900 may vary according to embodiments.

According to some embodiments, the filling layer 30 may be formed to remove an air gap between the light-emitting panel 10 and the color panel 20. The filling layer 30 may function as a buffer against external pressure or the like.

The filling layer 30 may be located on the plurality of lenses 900. The filling layer 30 may be arranged to cover the plurality of lenses 900. The filling layer 30 may be between the functional layer 500 and the color filter layer 600. According to some embodiments, the filling layer 30 may be between the functional layer 500 and the low refractive layer LRL. The filling layer 30 may be between the plurality of lenses 900 and the color filter layer 600. According to some embodiments, the filling layer 30 may be between the plurality of lenses 900 and the low refractive layer LRL. The filling layer 30 may be arranged to cover the first lenses 910 and the second lenses 930.

The filling layer 30 may have a refractive index lower than the refractive index of the plurality of lenses 900. That is, the plurality of lenses 900 may have a refractive index higher than a refractive index of the filling layer 30. The refractive index of the filling layer 30 may range, for example, from about 1.3 to about 1.6. For example, a difference between the refractive index of the plurality of lenses 900 and the refractive index of the filling layer 30 may range from about 0.1 to about 0.7. For example, the difference between the refractive index of the plurality of lenses 900 and the refractive index of the filling layer 30 may range from about 0.2 to about 0.7. A difference between a refractive index of the first lens 910 and the refractive index of the filling layer 30 may range from about 0.1 to about 0.7. A difference between a refractive index of the second lens 930 and the refractive index of the filling layer 30 may range from about 0.1 to about 0.7. When the refractive index of the plurality of lenses 900 and the refractive index of the filling layer 30 differ by about 0.1 or more, it may be seen that the light output efficiency is significantly improved, as described with reference to Table 1 below.

According to some embodiments, the filling layer 30 may include a thermosetting material or a photocurable material. The filling layer 30 may include an organic material such as methyl silicone, phenyl silicone, or polyimide. However, one or more embodiments are not limited thereto. The filling layer 30 may include an organic sealant such as a urethane-based resin, an epoxy-based resin, or an acrylic resin, or an inorganic sealant such as silicone. The filling layer 30 may include, for example, hollow silica particles, non-hollow silica particles, nanosilicate particles, and/or porogen particles.

**[Table 1]**

| | | Refractive index | | | |
|---|---|---|---|---|---|
| | Lens | Filling layer | Lens size | Lens spacing | Improvement |
| Experimental Example 1 | 1.55 | 1.51 | 8 µm | 0 | 102 % |
| Experimental Example 2 | 1.65 | 1.51 | 8 µm | 0 | 108 % |
| Experimental Example 3 | 1.75 | 1.51 | 8 µm | 0 | 113 % |
| Experimental Example 4 | 1.85 | 1.51 | 8 µm | 0 | 119 % |

Table 1 shows the degree of improvement in light output efficiency of a display apparatus including lenses having different refractive indexes. In each of Experimental Examples 1 to 4, the degree of improvement in the light output efficiency was measured compared to a display apparatus not including a lens. Also, in Experimental Examples 1 to 4, the lens size and shape was the same, but only the refractive index of the lens was different. Referring to Table 1, it may be seen that the degree of improvement in the light output efficiency increased as a difference in refractive index between lenses and a filling layer increased. In Experimental Example 1 in which the difference in refractive index between the lenses and the filling layer was 0.04, the degree of improvement in the light output efficiency was 102 %. In Experimental Example 2 in which the difference in refractive index between the lenses and the filling layer was 0.14, the degree of improvement in the light output efficiency was 108 %. In Experimental Example 3 in which the difference in refractive index between the lenses and the filling layer was 0.24, the degree of improvement in the light output efficiency was 113 %. In Experimental Example 4 in which the difference in refractive index between the lenses and the filling layer was 0.34, the degree of improvement in the light output efficiency was 119 %.

Unlike the degree of improvement in the light output efficiency being 102 % in Experimental Example 1 in which the difference in refractive index between the lenses and the filling layer was 0.04, it may be seen that, in Experimental Examples 2, 3, and 4 in which the difference in refractive index between the lenses and the filling layer was 0.1 or more, the light output efficiency was improved by 108 % or more. As described above, when a refractive index of the lenses and a refractive index of the filling layer differ by about 0.1 or more, the light output efficiency is improved.

Referring back to FIG. 5, the color panel 20 may include the second substrate 700 and the color filter layer 600. According to some embodiments, the color panel 20 may further include the low refractive layer LRL.

Light emitted by the light-emitting panel 10 may be incident light incident on the color panel 20. For example, light emitted by each of the first to third light-emitting diodes LED1, LED2, and LED3 may travel to the color panel 20 as incident light. As a part of incident light passes through the color panel 20, the part of the incident light may be color-converted and emitted to the outside, and the other part of the incident light may pass through the color panel 20 without color conversion and be emitted to the outside.

The color panel 20 may include a central area CA overlapping light-emitting diodes. According to some embodiments, the central area CA may include a first central area CA1, a second central area CA2, and a third central area CA3. The first central area CA1 may overlap the first light-emitting diode LED1 and the first emission area EA1. The second central area CA2 may overlap the second light-emitting diode LED2 and the second emission area EA2. The third central area CA3 may overlap the third light-emitting diode LED3 and the third emission area EA3.

For example, as light (e.g., blue light Lb) emitted from the first light-emitting diode LED1 passes through the color panel 20, the light may be converted into red light Lr and emitted to the outside through the first central area CA1. As light (e.g., blue light Lb) emitted from the second light-emitting diode LED2 passes through the color panel 20, the light may be converted into green light Lg and emitted to the outside through the second central area CA2. As light (e.g., blue light Lb) emitted from the third light-emitting diode LED3 passes through the color panel 20, the light may be emitted to the outside through the third central area CA3 without color conversion. As described above, the color panel 20 may include the first central area CA1, the second central area CA2, and the third central area CA3 that overlap the first to third light-emitting diodes LED1, LED2, and LED3, respectively, and emit light of different colors. The first central area CA1, the second central area CA2, and the third central area CA3 of the color panel 20 may correspond to the first subpixel PX1, the second subpixel PX2, and the third subpixel PX3 of the display apparatus 1, respectively. In this case, when an element corresponds to another element, it means that the elements overlap each other when seen from a direction (e.g., a +z axis direction) perpendicular to one surface of the second substrate 700.

Hereinafter, a stacked structure of the color panel 20 is described in detail.

According to some embodiments, the second substrate 700 may be arranged over the first substrate 100 with light-emitting diodes therebetween. The second substrate 700 may be referred to as an upper substrate or a light-transmissive base layer. The second substrate 700 may be located on the color filter layer 600.

The second substrate 700 may include glass or a polymer resin. In a case where the second substrate 700 is flexible or bendable, the second substrate 700 may include a polymer resin such as polyethersulfone, polyacrylate, polyetherimide, polyethylene naphthalate, polyethylene terephthalate, polyphenylene sulfide, polyarylate, polyimide, polycarbonate, and cellulose acetate propionate.

The color filter layer 600 may be located on the second substrate 700. The color filter layer 600 may be located on a lower surface of the second substrate 700, which is positioned in a direction (e.g., a -z direction) from the second substrate 700 toward the first substrate 100. That is, the color filter layer 600 may be arranged under the second substrate 700.

The color filter layer 600 may include the first color filter 610, the second color filter 620, and the third color filter 630. The first color filter 610 may be arranged over the first central area CA1. The second color filter 620 may be arranged over the second central area CA2. The third color filter 630 may be arranged over the third central area CA3. The first color filter 610 may be arranged at a position corresponding to the first emission area EA1. The second color filter 620 may be arranged at a position corresponding to the second emission area EA2. The third color filter 630 may be arranged at a position corresponding to the third emission area EA3. The first color filter 610 may overlap the first color conversion layer 510. The second color filter 620 may overlap the second color conversion layer 520. The third color filter 630 may overlap the transmission layer 530.

Each of the first to third color filters 610, 620, and 630 may include a photosensitive resin. Also, each of the first to third color filters 610, 620, and 630 may include a pigment or dye that exhibits a unique color.

The first color filter 610 may include a red color filter. For example, the first color filter 610 may pass light having a wavelength in a range of about 580 nm to about 780 nm. The first color filter 610 may include a red pigment or dye. The second color filter 620 may include a green color filter. For example, the second color filter 620 may pass light having a wavelength in a range of about 500 nm to about 580 nm. The second color filter 620 may include a green pigment or dye. The third color filter 630 may include a blue color filter. For example, the third color filter 630 may pass light having a wavelength in a range of about 380 nm to about 500 nm. The third color filter 630 may include a blue pigment or dye.

The color filter layer 600 may reduce reflection of external light of the display apparatus 1. For example, when external light reaches the first color filter 610, only light having preset wavelengths as described above may pass through the first color filter 610, and light having other wavelengths may be absorbed by the first color filter 610. Accordingly, only the light having the preset wavelengths among external light incident on the display apparatus 1 may pass through the first color filter 610, and a part of the passed-through light may be reflected on the opposite electrode 330 and/or the first pixel electrode 310R thereunder, and emitted back to the outside. Because only a part of external light incident on a place where the first subpixel PX1 is located is reflected to the outside, the reflection of external light may be reduced. The above description may also be applied to the second color filter 620 and the third color filter 630.

The first color filter 610, the second color filter 620, and the third color filter 630 may overlap each other. The first color filter 610, the second color filter 620, and the third color filter 630 may overlap each other between one of the central areas CA and another of the central areas CA.

For example, the first color filter 610, the second color filter 620, and the third color filter 630 may overlap each other between the first central area CA1 and the second central area CA2. In this case, the third color filter 630 may be between the first central area CA1 and the second central area CA2. The first color filter 610 may extend from the first central area CA1 and overlap the third color filter 630. The second color filter 620 may extend from the second central area CA2 and overlap the third color filter 630.

For example, the first color filter 610, the second color filter 620, and the third color filter 630 may overlap each other between the second central area CA2 and the third central area CA3. The first color filter 610 may be between the second central area CA2 and the third central area CA3. The second color filter 620 may extend from the second central area CA2 and overlap the first color filter 610. The third color filter 630 may extend from the third central area CA3 and overlap the first color filter 610.

For example, the first color filter 610, the second color filter 620, and the third color filter 630 may overlap each other between the third central area CA3 and the first central area CA1. The second color filter 620 may be between the third central area CA3 and the first central area CA1. The third color filter 630 may extend from the third central area CA3 and overlap the second color filter 620. The first color filter 610 may extend from the first central area CA1 and overlap the second color filter 620.

As described above, the first color filter 610, the second color filter 620, and the third color filter 630 may overlap each other to define a light-shielding portion BM. According to some embodiments, the light-shielding portion BM may be formed by overlapping two color filter materials selected from among the first color filter 610, the second color filter 620, and the third color filter 630. Accordingly, the color filter layer 600 may prevent or reduce color mixing without a separate light-shielding member.

According to some embodiments, the color panel 20 may further include an overcoat layer OC over the color filter layer 600. The overcoat layer OC may be arranged over the color filter layer 600 and protect the color filter layer 600. The overcoat layer OC may include an organic material and provide a planarized surface.

The low refractive layer LRL may be arranged over the color filter layer 600. The low refractive layer LRL may be entirely arranged over the color filter layer 600. For example, the low refractive layer LRL may be entirely arranged over the first color filter 610, the second color filter 620, and the third color filter 630. The low refractive layer LRL may be between the color filter layer 600 and the filling layer 30. The low refractive layer LRL may be arranged over the overcoat layer OC. The low refractive layer LRL may be between the overcoat layer OC and the filling layer 30.

The refractive index of the low refractive layer LRL may be lower than the refractive index of the functional layer 500. The refractive index of the low refractive layer LRL may be lower than the refractive index of the plurality of lenses 900. The low refractive layer LRL may have a refractive index lower than refractive indexes of a second capping layer CL2 and a third capping layer CL3. For example, the refractive index of the low refractive layer LRL may be about 1.1 to about 1.4. In some embodiments, the low refractive layer LRL may be omitted.

The low refractive layer LRL may include an organic material and particles dispersed in the organic material. For example, the low refractive layer LRL may include, for example, an organic material such as an acrylic resin, a siloxane-based resin, a urethane-based resin, or an imide-based resin. The low refractive layer LRL may include hollow silica particles, non-hollow silica particles, nanosilicate particles, magnesium fluoride (MgF₂), iron oxide (Fe₃O₄), and/or porogen particles.

The low refractive layer LRL may reflect a part of light emitted from the functional layer 500 to the second substrate 700 back toward the functional layer 500. That is, the low refractive layer LRL recycles at least a part of light passing through the functional layer 500 and emitted toward the second substrate 700, and may thus improve light usage efficiency and may improve light efficiency of the display apparatus 1.

The second capping layer CL2 may be between the low refractive layer LRL and the filling layer 30. The second capping layer CL2 may protect the low refractive layer LRL. The third capping layer CL3 may be between the low refractive layer LRL and the overcoat layer OC. The third capping layer CL3 may protect the color filter layer 600 and the overcoat layer OC. Each of the second capping layer CL2 and the third capping layer CL3 may prevent or reduce impurities such as moisture and/or air from penetrating from the outside and damaging or contaminating the low refractive layer LRL and the color filter layer 600. Each of the second capping layer CL2 and the third capping layer CL3 may include an inorganic material or an organic material.

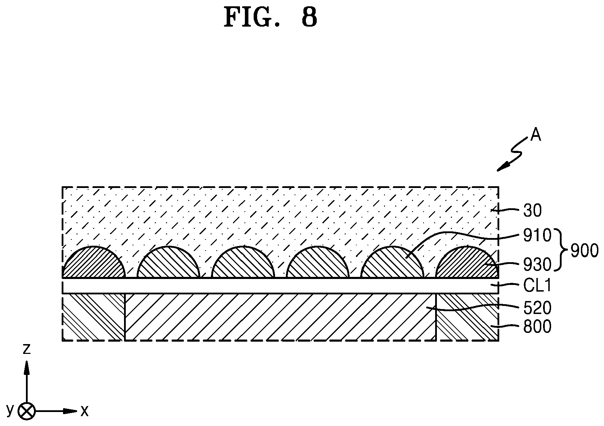

FIG. 8 is an enlarged view of a region "A" of the display apparatus of FIG. 5, according to some embodiments. FIG. 8 shows aspects of embodiments in which the arrangement of the plurality of lenses 900 described with reference to FIGS. 5 and 6 is changed, and changes are mainly described.

Referring to FIG. 8, the plurality of lenses 900 may be spaced apart from each other. That is, the plurality of lenses 900 may not be in contact with each other. The plurality of first lenses 910 overlapping one opening COP (see FIG. 5) of the bank layer 800 may be spaced apart from each other. For example, as shown in FIG. 8, the plurality of first lenses 910 overlapping the second color conversion layer 520 may be spaced apart from each other. According to some embodiments, the first lens 910 and the second lens 930 may be spaced apart from each other.

According to some embodiments, a distance between centers of a pair of lenses 900 adjacent to each other among the plurality of lenses 900 may be greater than a width of one lens 900. That is, the pair of lenses 900 adjacent to each other may be spaced apart from each other at an interval therebetween.

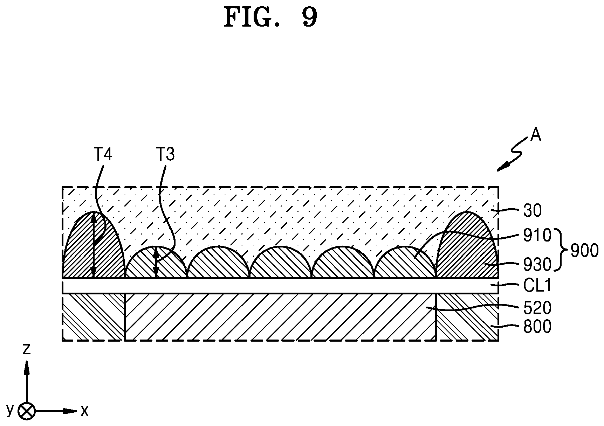

FIG. 9 is an enlarged view of a region "A" of the display apparatus of FIG. 5, according to some embodiments. FIG. 9 shows aspects of embodiments in which the arrangement of the plurality of lenses 900 described with reference to FIGS. 5 and 6 is changed, and changes are mainly described.

Referring to FIG. 9, a thickness T3 of the first lens 910 and a thickness T4 of the second lens 930 may be different from each other. The thickness T3 of the first lens 910 may be less than the thickness T4 of the second lens 930. The first lens 910 and the second lens 930 having different thicknesses may be simultaneously formed through a half-tone mask process. Even in this case, the first lens 910 and the second lens 930 may include the same material and have similar shapes.

In the embodiments of FIG. 9, the plurality of lenses 900 in contact with each other are shown, but one or more embodiments are not limited thereto. For example, even when the plurality of lenses 900 are spaced apart from each other as in the embodiments described with reference to FIG. 8, a thickness of the second lens 930 may be greater than a thickness of the first lens 910.

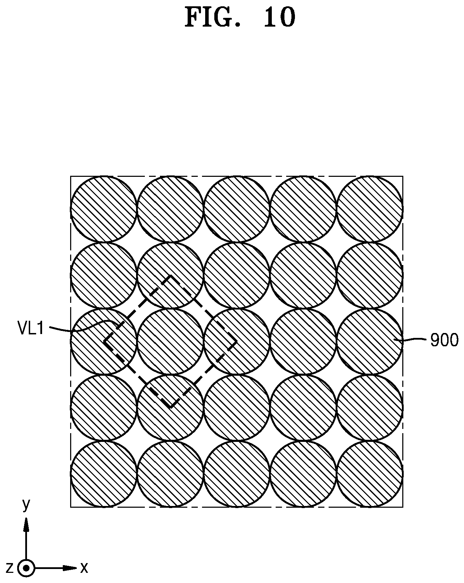

FIG. 10 is a schematic plan view of an arrangement of a plurality of lenses according to some embodiments. FIG. 10 illustrates the arrangement of the plurality of lenses 900 over the functional layer 500 (see FIG. 5) when seen from a direction perpendicular to the first substrate 100.

Referring to FIG. 10, the plurality of lenses 900 may be arranged such that a virtual line VL1 connecting centers of lenses closest to one of the plurality of lenses 900 forms a square. That is, the number of lenses closest to each of the plurality of lenses 900 may be four. One of the lenses closest to one lens among the plurality of lenses 900 may be arranged in a first direction (e.g., a ±y direction), and another of the lenses may be arranged in a second direction (e.g., a ±x direction), which is perpendicular to the first direction.

A distance between the plurality of lenses 900 may be closest in the first direction (e.g., the ±y direction) and the second direction (e.g., the ±x direction). According to some embodiments, the plurality of lenses 900 may be arranged to be in contact with each other in the first direction (e.g., the ±y direction) and may be arranged to be in contact with each other in the second direction (e.g., the ±x direction).

In the embodiments of FIG. 10, the plurality of lenses 900 in contact with each other are shown, but one or more embodiments are not limited thereto. For example, even when the plurality of lenses 900 are spaced apart from each other as in the embodiments described with reference to FIG. 8, the plurality of lenses 900 may form the same arrangement as shown in FIG. 10.

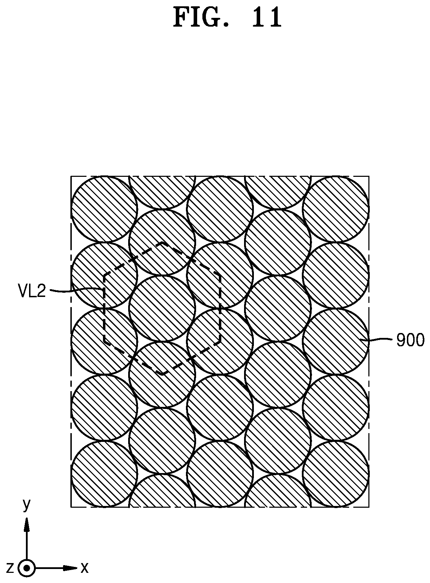

FIG. 11 is a schematic plan view of an arrangement of a plurality of lenses according to some embodiments. FIG. 11 illustrates the arrangement of the plurality of lenses 900 over the functional layer 500 (see FIG. 5) when seen from a direction perpendicular to the first substrate 100.

Referring to FIG. 11, the plurality of lenses 900 may be arranged such that a virtual line VL2 connecting centers of lenses closest to one of the plurality of lenses 900 forms a hexagon. That is, the number of lenses closest to each of the plurality of lenses 900 may be six. One of the lenses closest to one lens among the plurality of lenses 900 may be arranged in the first direction (e.g., a ±y direction), another of the lenses may be arranged in the second direction (e.g., a ±x direction), which is perpendicular to the first direction, and another of the lenses may be arranged in a third direction, which is a diagonal direction between the first and second directions.

A distance between the plurality of lenses 900 may be closest in the first direction (e.g., the ±y direction) and the third direction, which is the diagonal direction. According to some embodiments, the plurality of lenses 900 may be arranged to be in contact with each other in the first direction (e.g., the ±y direction) and may be arranged to be in contact with each other in the third direction, which is the diagonal direction.

In the embodiments of FIG. 11, the plurality of lenses 900 in contact with each other are shown, but one or more embodiments are not limited thereto. For example, even when the plurality of lenses 900 are spaced apart from each other as in the embodiments described with reference to FIG. 8, the plurality of lenses 900 may form the same arrangement as shown in FIG. 11.

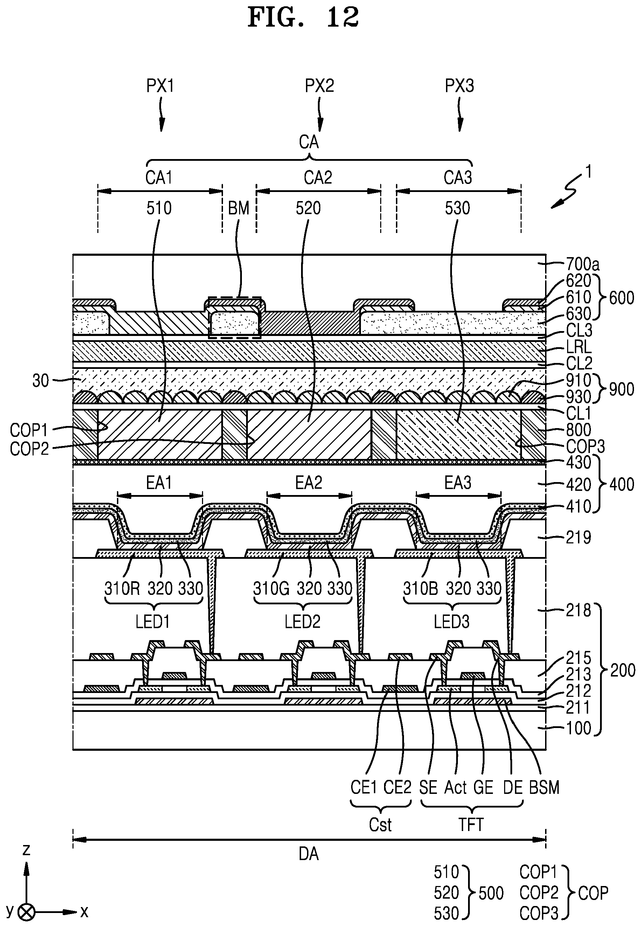

FIG. 12 is a schematic cross-sectional view of a display apparatus 1 according to some embodiments. FIG. 12 shows modifications to the embodiments of FIG. 5, and descriptions overlapping with those described with reference to FIGS. 5 to 7 are omitted, and changes are mainly described.

Referring to FIG. 12, the display apparatus 1 may include a circuit layer 200, a light-emitting diode layer 300 on the circuit layer 200, an encapsulation layer 400 on the light-emitting diode layer 300, a functional layer 500 on the encapsulation layer 400, a plurality of lenses 900 on the functional layer 500, a filling layer 30 on the plurality of lenses 900, a color filter layer 600 on the filling layer 30, and a transmissive base layer 700a on the color filter layer 600, which are all sequentially stacked on the first substrate 100. According to some embodiments, a low refractive layer LRL may be further provided between the filling layer 30 and the color filter layer 600.

In the embodiments of FIG. 12, after the functional layer 500, the plurality of lenses 900, the filling layer 30, and the color filter layer 600 are sequentially formed over the encapsulation layer 400, the transmissive base layer 700a may be formed by being directly applied and cured on the color filter layer 600. For example, the transmissive base layer 700a may include a transmissive organic material. For example, the transmissive base layer 700a may include a transmissive organic material such as an acrylic resin.

A structure in the embodiments of FIG. 12 may be applied in the same or similar manner to the embodiments described with reference to FIGS. 8 to 11.

As described above, the disclosure has been described with reference to the one or more embodiments shown in the accompanying drawings, but should be considered in a descriptive sense only. Those of ordinary skill in the art will understand that various modifications and changes to the embodiments may be made therefrom. Therefore, the true technical scope of protection of the disclosure should be defined by the technical spirit of the appended claims.

## Claims

1. A display apparatus comprising:
a light-emitting panel including a first substrate, a plurality of light-emitting diodes on the first substrate, a bank layer including a plurality of openings, a functional layer in the openings of the bank layer, and a plurality of lenses on the functional layer;
a color panel on the light-emitting panel, the color panel including a second substrate and a color filter layer on the second substrate; and
a filling layer covering the plurality of lenses between the light-emitting panel and the color panel, the filling layer having a refractive index lower than a refractive index of the plurality of lenses,
wherein the plurality of lenses include a first lens overlapping the functional layer, and a second lens overlapping a partition wall of the bank layer.

2. The display apparatus of claim 1, wherein the first lens and the second lens include a same material.

3. The display apparatus of claim 1, wherein a difference between a refractive index of the plurality of lenses and a refractive index of the filling layer is in a range of 0.1 to 0.7.

4. The display apparatus of claim 1, wherein a refractive index of the plurality of lenses is in a range of 1.65 to 2.

5. The display apparatus of claim 1, wherein a refractive index of the filling layer is in a range of 1.3 to 1.6.

6. The display apparatus of claim 1, wherein a thickness of the first lens is equal to a thickness of the second lens.

7. The display apparatus of claim 1, wherein a thickness of the first lens is less than a thickness of the second lens.

8. The display apparatus of claim 1, wherein the plurality of lenses are arranged such that a virtual line connecting centers of lenses closest to one lens among the plurality of lenses forms a square.

9. The display apparatus of claim 1, wherein the plurality of lenses are arranged such that a virtual line connecting centers of lenses closest to one lens among the plurality of lenses forms a hexagon.

10. The display apparatus of claim 1, wherein a distance between centers of a pair of lenses adjacent to each other among the plurality of lenses is equal to a width of each of the lenses.

11. The display apparatus of claim 1, wherein the plurality of lenses are spaced apart from each other.

12. The display apparatus of claim 1, wherein the plurality of openings of the bank layer include a first opening, a second opening, and a third opening, the functional layer includes a first color conversion layer in the first opening of the bank layer, a second color conversion layer in the second opening of the bank layer, and a third color conversion layer in the third opening of the bank layer,
the color filter layer includes a first color filter overlapping the first color conversion layer, a second color filter overlapping the second color conversion layer, and a third color filter overlapping the third color conversion layer, and
the first lens is provided as a plurality of first lenses in areas overlapping the first color conversion layer, the second color conversion layer, and the third color conversion layer, respectively.

13. The display apparatus of claim 1, further comprising a low refractive layer between the filling layer and the color filter layer, the low refractive layer having a refractive index lower than a refractive index of the functional layer.

14. A display apparatus comprising:
a substrate;
a plurality of light-emitting elements on the substrate;
an encapsulation layer covering the plurality of light-emitting elements;
a bank layer on the encapsulation layer and having a plurality of openings;
a functional layer in the plurality of openings of the bank layer;
a light collection layer on the functional layer and overlapping the functional layer;
a spacer on a same layer as the light collection layer on the functional layer, the spacer overlapping a partition wall of the bank layer;
a filling layer on the light collection layer and the spacer; and
a color filter layer on the filling layer,
wherein the light collection layer has a refractive index higher than a refractive index of the filling layer.

15. The display apparatus of claim 14, wherein the light collection layer and the spacer include a same material as each other.

16. The display apparatus of claim 14, wherein a difference between a refractive index of the light collection layer and a refractive index of the filling layer is in a range of 0.1 to 0.7.

17. The display apparatus of claim 14, wherein a thickness of the light collection layer is less than or equal to a thickness of the spacer.

18. The display apparatus of claim 14, further comprising a low refractive layer between the filling layer and the color filter layer, the low refractive layer having a refractive index lower than a refractive index of the functional layer.

19. A display apparatus comprising:
a light-emitting panel including a first substrate, a plurality of light-emitting diodes on the first substrate, a bank layer including a plurality of openings, a functional layer in the openings of the bank layer, and a plurality of lenses on the functional layer;
a color panel on the light-emitting panel, the color panel including a second substrate and a color filter layer on the second substrate; and
a filling layer covering the plurality of lenses between the light-emitting panel and the color panel,
wherein a difference between a refractive index of the plurality of lenses and a refractive index of the filling layer is in a range of 0.1 to 0.7.

20. The display apparatus of claim 19, wherein the plurality of lenses have a refractive index higher than a refractive index of the functional layer, and the filling layer has a refractive index lower than the refractive index of the plurality of lenses.
